# FASCICULE DE BREVET EUROPEEN

(11) **EP 0 924 706 B1**
(45) Date de publication et mention de la délivrance du brevet: **25.02.2004**
(21) Numéro de dépôt: 98403186.4
(22) Date de dépôt: 16.12.1998
(51) Int. Cl.: G11C 5/06, G06F 13/42

(54) **Procédé de gestion d'un circuit éléctronique et unité de gestion pour sa mise en oeuvre**
Steuerverfahren für elektronische Schaltung und Steuereinheit zu dessen Durchführung
Control method of an electronic circuit and control unit for its implementation

(30) Priorité: 19.12.1997 FR 9716193
(43) Date de publication de la demande: 23.06.1999
(73) Titulaire: STMicroelectronics S.A., 92120 Montrouge (FR)
(72) Inventeur: Gaultier, Jean-Marie, Cabinet Ballot-Schmit, 75116 Paris (FR)
(74) Mandataire: Ballot, Paul

(56) Documents cités:
- US-A- 4 638 481
- US-A- 5 241 161
- US-A- 5 682 496
- MOSS B: "A FLEXIBLE SIZE 3-WIRE SERIAL EEPROM INTERFACE" MOTOROLA TECHNICAL DEVELOPMENTS, vol. 21, 1 février 1994, pages 23-26, XP000438083

## Description

La présente invention se rapporte à un procédé de gestion d'un circuit électronique du type comportant au moins une broche d'accès pour recevoir et/ou délivrer des signaux de gestion, ainsi qu'à une unité de gestion pour la mise en oeuvre dudit procédé.

Elle s'applique dans le domaine de la conception des systèmes électroniques, notamment des systèmes incorporant des circuits électroniques numériques.

On sait que la mise au point et la fabrication d'un tel circuit sont très coûteuses. Tout d'abord, il est nécessaire de définir le circuit d'un point de vue fonctionnel. Il faut ensuite le simuler à l'aide de logiciels de conception assistée par ordinateur. Puis il faut réaliser le dessin des masques nécessaires à sa réalisation physique sur un substrat de circuit intégré (silicium). Et enfin, il faut encore le tester une fois son intégration dans un boîtier plastique effectuée.

C'est pourquoi les fabricants de circuits intégrés réalisent souvent de nouveaux produits à partir de produits antérieurs, en les adaptant de manière à ne modifier ce qui est strictement nécessaire.

On sait aussi réaliser des circuits intégrés à application spécifique (Asic) en assemblant une pluralité de blocs fonctionnels extraits d'une collection de schémas de circuits élémentaires (on parle de "schématèque" dans le jargon de l'homme du métier). L'avantage réside dans le fait que le schéma des blocs fonctionnels est conçu et validé à l'avance. De même, les vecteurs de test qui sont à utiliser pour en vérifier le bon fonctionnement sont connus et peuvent être réutilisés pour tester le circuit intégré bloc par bloc. Seuls de nouveaux vecteurs de test doivent être crées pour vérifier le bon fonctionnement de l'ensemble. Tout cela contribue à abaisser le temps de développement et donc le coût d'un nouveau circuit intégré.

Cependant, il peut arriver qu'un circuit intégré existant, ou un bloc fonctionnel disponible dans une schématèque, tout en correspondant d'un point de vue fonctionnel au cahier des charges du nouveau circuit à concevoir, ne puisse être repris à l'identique dans le cadre de cette nouvelle application. Cela peut être le cas, par exemple, lorsque le circuit antérieur est un circuit logique commandé par, ou délivrant, des signaux électriques présentant des niveaux de tension incompatibles avec ceux de l'application envisagée. Il peut aussi s'agir d'un circuit antérieur communiquant avec l'extérieur selon un protocole spécifique, qu'il n'est pas possible de mettre en oeuvre dans l'application nouvelle envisagée. L'homme du métier est alors contraint de modifier substantiellement le circuit antérieur ou le bloc fonctionnel disponible ce qui, en pratique, requiert presque autant de temps et revient pratiquement aussi cher que de développer un circuit complètement nouveau. Or ces coûts peuvent peser très lourd dans le coût de fabrication d'un nouveau circuit intégré surtout si les volumes de production envisagés sont trop faibles pour permettre de les amortir sur le long terme.

Le document US-A-5 241 161 décrit un procédé de gestion d'une carte à puce. La carte à puce comprend une unité de contrôle qui reconnaît des signaux d'interrogation envoyés à la carte, et répond automatiquement en envoyant un code d'identification. Le signal d'identification est reçu par l'intermédiaire d'une liaison numérique sans contact. Des circuits d'entrée sont connecté à l'unité de contrôle et convertissent les signaux reçus en signaux électriques numériques. Des signaux de sortie sont connectés à l'unité de contrôle et transmettent le code d'identification par une liaison série sans contact. Le préambule de la revendication 1 se fonde sur ce document.

Le document US-A-4 638 481 décrit un dispositif de test de niveaux logiques. Un tel équipement applique des niveaux logiques sur des broches de test, par l'intermédiaire de flip-flops. L'état logique des flips-flops est contrôlé par des commandes. lues dans une RAM de commande. La RAM fournit des mots de 4 bit sur les entrées de chaque circuit logique.

Le but de la présente invention est de permettre de réutiliser, sans le modifier, le dessin d'un circuit électronique du type défini en introduction dans des applications où la gestion du circuit intégré ne peut être assurée par l'intermédiaire de n sources de signaux de gestion (n strictement supérieur à l'unité) mais, au contraire, par l'intermédiaire d'un unique moyen de transfert de données en série.

Ce but est atteint, conformément à l'invenetion grâce à un procédé de gestion d'un circuit électronique selon la revendication 1. Notamment, le circuit intégré envisagé ici est une mémoire de carte téléphonique qui, selon une norme française, est gérée de l'extérieur par l'intermédiaire de cinq broches de contact dont une broche est connectée à une source de tension d'alimentation positive et dont une autre est connectée à la masse. C'est donc par l'intermédiaire de trois broches d'accès que le circuit reçoit ou délivre des signaux de gestion.

Le moyen de transfert de données en série peut être, par exemple, une ligne de transmission bidirectionnelle de données, soit de type filaire, soit de type fibre optique. Il peut aussi s'agir d'une liaison hertzienne, notamment dans la bande radiofréquence.

L'unité de gestion qui met en oeuvre le procédé ci-dessus a donc la fonction d'une interface entre, d'une part, le moyen de transfert de données en série, et, d'autre part, le circuit électronique accessible par l'intermédiaire de ses broches d'accès. Ainsi le circuit électronique peut être utilisé sans modification de sa structure, et ce, malgré le fait qu'il soit piloté par une centrale de commande déportée, telle que par exemple un microprocesseur, avec laquelle il communique par l'intermédiaire du moyen de transmission de données en série selon un protocole de transmission série de type déterminé.

Selon une caractéristique avantageuse de l'invention, le signal de gestion étant généré en vue d'être transmis sur une entrée adaptée du circuit électronique, deux opérations identiques successives ont pour effet, respectivement, de faire passer le signal de gestion concerné d'un premier état logique à un second état logique différent du premier, et de le refaire passer dans l'état logique dans lequel il se trouvait à l'origine. Cette disposition permet de commander les transitions 1->0 et 0->1 des signaux de gestion à l'aide d'un seul mot de commande. Le rendement du protocole, qui peut s'exprimer comme le nombre d'actions différentes qu'il est possible de commander avec un format et une taille de message déterminés, est ainsi amélioré.

L'invention propose aussi une unité de gestion pour la mise en oeuvre du procédé ci-dessus.

D'autres caractéristiques et avantages de l'invention apparaîtront encore à la lecture de la description qui va suivre. Celle-ci est purement illustrative et doit être lue en regard des dessins annexés sur lesquels on a représenté:
- à la figure 1: un schéma d'une unité de gestion selon l'invention;
- à la figure 2: une table donnant la définition et la valeur de mots de commande selon l'invention;
- à la figure 3: une séquence de mots de commande pour réaliser une opération dans le circuit électronique, selon le procédé de l'invention;
- aux figures 4a à 4c: des chronogrammes de signaux de gestion correspondant à la séquence de la figure 3;
- à la figure 5: une séquence de mots de commande pour la réalisation d'une autre opération selon le procédé de l'invention.
- aux figures 6a à 6c: des chronogrammes de signaux de gestion correspondant à la séquence de la figure 5.

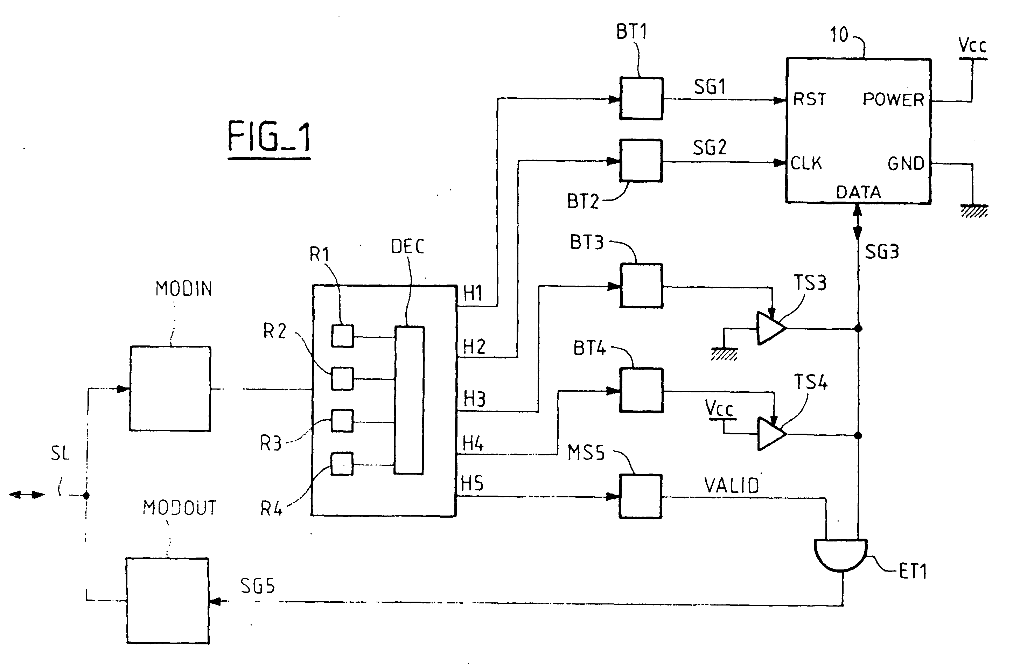

A la figure 1, on a représenté un mode de réalisation possible d'une unité de gestion conforme au principe de l'invention. Cette unité de gestion est disposée entre d'une part un moyen de transmission de données en série, ici représenté par une ligne SL, et d'autre part un circuit électronique 10 tel qu'une mémoire de carte téléphonique.

La ligne SL peut directement être une ligne de transfert de données, éventuellement mais non nécessairenent bidirectionnelle, notamment une liaison filaire (en cuivre) ou une fibre optique. Il peut également s'agir d'une liaison vers une antenne, de préférence une antenne émettrice/réceptrice pour le transfert de données en série par voie hertzienne, notamment dans la bande radiofréquence (liaison RF).

Dans l'exemple décrit, le circuit 10 comporte cinq broches de contact. Une première broche POWER reçoit un potentiel qui n'est autre qu'un potentiel d'alimentation positif Vcc délivré par une source d'alimentation. Une autre broche GND est connectée à un potentiel d'alimentation négatif ou à la masse. Enfin, les trois autres broches sont des broches d'accès pour recevoir et/ou délivrer des signaux de gestion du circuit 10. Pour une mémoire de carte téléphonique selon la norme française, qui fait l'objet du présent exemple de réalisation de l'invention, il s'agit des trois signaux de gestion suivants:
- un signal SG1, qui est un signal de commande reçu par la mémoire 10 sur un entrée RST; ce signal peut présenter deux valeurs logiques déterminées complémentaires 0 ou 1;
- un signal SG2, qui est un signal d'horloge reçu par la mémoire sur une entrée d'horloge CLK; ce signal peut également présenter deux valeurs logiques déterminées complémentaires 0 ou 1; les fronts montants de ce signal d'horloge rythment le fonctionnement de la mémoire 10;
- un signal de données SG3 reçu ou délivré par la mémoire 10 sur une broche d'entrée/sortie de données DATA; ce signal peut être généré par l'unité de gestion en vue d'être transmis sur la broche DATA fonctionnant alors en tant qu'entrée de la mémoire (signal SG3); il peut aussi être généré en vue d'être émis par l'unité de gestion sur le moyen de transfert de données SL, auquel cas la broche DATA fonctionne en tant que sortie de la mémoire (signal SG5); le moyen SL est alors un moyen de transfert bidirectionnel.

L'unité de gestion comporte un nodule d'entrée MODIN comportant des moyens d'extraction d'un mot de commande compris dans les données reçues en série par l'intermédiaire du moyen SL.

Dans une exemple, le mot de commande est codé sur quatre bits. La valeur des quatre bits d'un mot de commande extrait des données reçues est sauvegardée, respectivement, dans quatre registres de mémorisation R1 à R4. La sortie de ces registres est fournie en entrée d'un décodeur DEC qui décode le mot de commande. Un tel décodeur comprend, de façon classique, des circuits combinatoires tels que des portes logiques de type NAND, de type NOR, ... etc. les moyens de décodage ainsi formés des registres R1 à R4 et du décodeur DEC génèrent des signaux d'activation en fonction de la valeur du mot de commande. Dit autrement certains signaux d'activation, et dans l'exemple un seul à la fois des cinq signaux d'activation H1 à H5 représentés, sont activés pour certaines valeurs déterminées du mot de commande reçu. Par convention, on dira dans la suite qu'un signal quelconque est actif quand il est à l'état logique 1.

Les signaux d'activation H1 à H5 ont pour fonction de provoquer une opération modifiant l'état des signaux de gestion SG1, SG2, SG3 et SG5 générés par l'unité de gestion ainsi qu'il va maintenant être décrit.

L'unité de gestion comporte des bascules BT1-BT4 et MS5 qui sont commandées par les signaux d'activation respectivement H1 à H5. L'état logique de la sortie de ces bascules détermine directement ou indirectement l'état logique des signaux de gestion générés. C'est donc la fonction de ces bascules que de déterminer directement ou indirectement l'état logique des signaux de gestion et en même temps, de le maintenir aussi longtemps que la bascule est maintenue dans un état logique correspondant.

La sortie de la bascule BT1 est connectée à la broche RST du circuit 10. Celle de la bascule BT2 est connectée à l'entrée CLK du circuit 10. L'état logique des signaux de gestion SG1 et SG2 générés en sortie des bascules BT1 et BT2 respectivement, est donc déterminé directement par l'état logique de la sortie desdites bascules. En fait, ce sont les mêmes états logiques.

La sortie de la bascule BT3 est connectée à la borne de commande d'une première porte logique à trois états TS3 dont l'entrée est portée de manière permanente à la valeur logique 0 (elle est connectée à la masse), et dont la sortie est connectée à la broche DATA du circuit 10. De même, la sortie de la bascule BT4 est connectée à la borne de commande d'une seconde porte logique à trois états TS4 dont l'entrée est portée de manière permanente à la valeur logique 1 (elle est connectée à La source de potentiel Vcc), et dont la sortie est connectée à l'entrée DATA de même que celle de la porte ST3.

Avec ces connexions, le signal de gestion SG3 généré par l'unité de gestion en vue d'être transmis sur la broche DATA, qui est délivré par les sorties communes des portes TS3 et TS4, présente les niveaux logiques suivants:
- quand le signal d'activation H3 est actif, la porte TS3 est fermée et le signal de gestion SG3 est à l'état logique 0;
- quand le signal d'activation H4 est actif, la porte TS4 est fermée et le signal de gestion SG3 est à l'état logique 1;
- quand ni H3, ni H4 ne sont actifs, les portes TS3 et TS4 sont ouvertes et leurs sorties communes sont dans un état logique indéterminé, c'est-à-dire l'état HIZ dit état "haute impédance" (à moins bien sûr, comme on le verra par la suite, que ce soit le contenu de la mémoire via la broche DATA qui impose un état logique déterminé).

On notera que le cas où H3 et H4 sont simultanément actifs est interdit, de par le câblage des moyens combinatoires du décodeur DEC, en sorte qu'aucun conflit entre les sorties des portes TS3 et TS4 n'est à redouter. L'état logique du signal de gestion SG3 est ici indirectement déterminé par l'état logique des signaux d'activation H3 et H4, dans la mesure où il dépend d'une part de l'état fermé ou ouvert des portes TS3 et TS4 et d'autre part de l'état logique en entrée de celle de ces portes qui est fermée le cas échéant.

Selon une caractéristique avantageuse, les bascules BT1 à BT4 sont des bascules de type T, qui présentent la particularité de changer d'état en sortie à chaque fois qu'un front montant se produit sur leur entrée d'horloge. Les signaux d'activation H1 à H4 sont transmis sur les entrées d'horloges des bascules BT1 à BT4 respectivement. Ainsi que l'homme du métier ne l'ignore pas, une bascule de type T se réalise facilement à l'aide d'une bascule de type RS, ou de type JK, dont les deux entrées R et S, ou J et K respectivement, sont toutes les deux portées au potentiel Vcc.

L'avantage d'une bascule de type T réside dans le fait que partant d'un état logique déterminé en sortie de chaque bascule BT1 à BT4, deux opérations identiques successivement effectuées (même entrecoupées le cas échéant par une ou plusieurs opération(s) de nature différente) ont pour effet, respectivement, de faire passer le signal de gestion concerné par ces opérations d'un premier à un second état logique, et de le refaire passer dans l'état logique dans lequel il se trouvait à l'origine.

Ceci est avantageux car, avec un même mot de commande, respectivement RESET ou CLOCK, on peut commander à la fois la transition montante 0->1 et la transition descendante 1->0 du signal de commande SG1 ou du signal d'horloge SG2. L'opération effectuée à réception de l'un de ces mots de commande consiste ainsi à faire basculer le signal de gestion concerné d'un état logique déterminé 0 ou 1 dans lequel il se trouve vers l'état logique inverse (ou complémentaire) de celui-ci.

De même, en ce qui concerne le signal de gestion SG3, la réception successive d'un même mot de commande IOIN0 ou IOIN1 provoque l'opération consistant à faire passer le signal de gestion SG3 dans un état logique déterminé, respectivenent 0 ou 1, lorsqu'il se trouve dans l'état logique indéterminé HIZ, puis inversement, de le faire passer dans l'état logique indéterminé HIZ lorsqu'il se trouve dans un état Logique déterminé 0 ou 1.

L'avantage qui découle de ce qui précède réside dans le fait que cela limite le nombre de mot de commande différents que le décodeur DEC doit décoder. On parvient ainsi à optimiser le rendement du protocole de communication série entre la centrale de commande déportée (non représentée) et l'unité de gestion pour l'échange de données de gestion via le moyen de transfert SL.

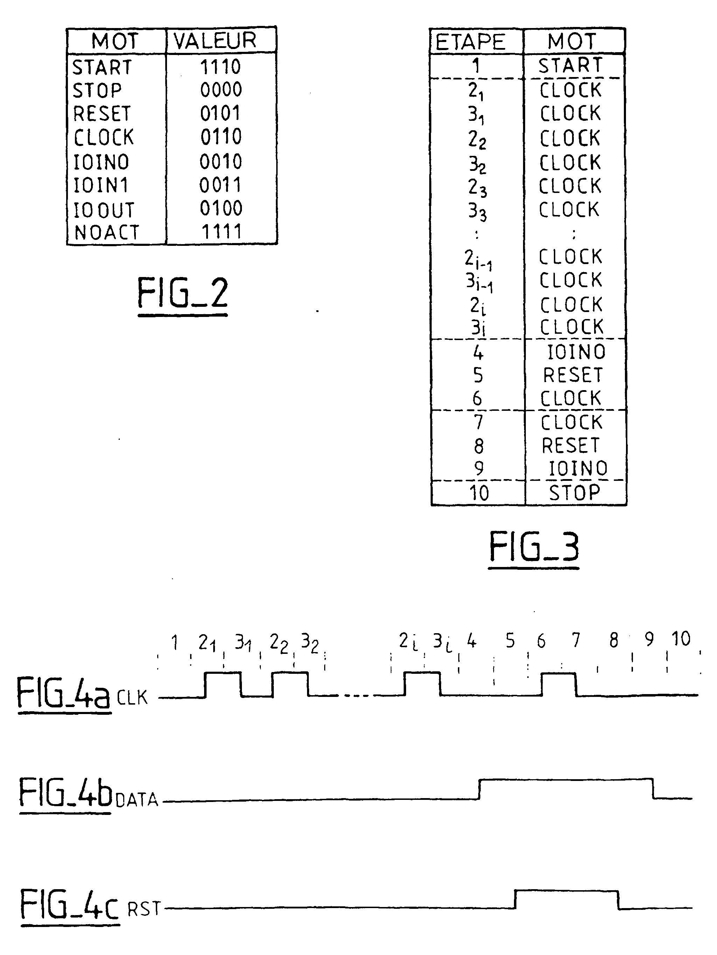

La figure 2 donne, à titre d'exemple, une table de huit mots de commande différents dont le nom utilisé dans le présent exposé est donné dans la colonne de gauche, et dont la valeur codée sur quatre bits est donnée dans la colonne de droite. Pour un rendement maximum du protocole, on pourrait évidemment coder la valeur des huit mots de commande sur trois bits au lieu de quatre comme envisagé. Néanmoins, avec quatre bits, on peut choisir des valeurs qui, compte tenu également des facteurs physiques intervenant dans le transfert des données sur le moyen SL, minimisent le risque d'erreur de décodage.

La sortie de la bascule MS5 est connectée à une première entrée d'une porte ET1 de type ET, dont la seconde entrée est connectée à la broche d'entrée/sortie DATA du circuit 10. La sortie de la porte ET1 délivre le signal de gestion SG5 généré par l'unité de gestion en vue d'être émis par cette dernière sur le moyen SL. Il s'agit d'un signal de données. L'état logique du signal SG5 est là encore indirectement déterminé d'une part par l'état logique de la sortie de la bascule BT5 commandée par le signal d'activation H5, et d'autre part, par l'état logique de la broche DATA fonctionnant en tant que sortie de la mémoire 10 en mode lecture.

Ainsi qu'on l'aura compris, partant d'un état initial où la sortie de la bascule BT5 est à l'état logique 0, l'opération effectuée par l'unité de gestion après le décodage du mot de commande IOOUT extrait des données reçues, consiste à mettre le signal de gestion SG5 dans un état logique déterminé en fonction de l'état logique de la broche DATA. Avec une porte ET1 de type ET, il s'agit d'une recopie de l'état logique de la sortie DATA. Mais avec une porte de type NON ET, il s'agirait d'une inversion de cet état logique.

On observera en effet que la nature de la porte ET1 représentée ici (i.e. une porte logique de type ET), doit être comprise comme un exemple parmi d'autres qui permettraient tout aussi bien de remplir la fonction allouée à cette porte. Notamment, on peut penser à une porte logique de type NON ET, à une porte logique à trois états ou encore à un multiplexeur correctement agencés.

Le signal SG5 généré en sortie de la porte ET1 est transmis sur une entrée d'un module de sortie MODOUT comportant des moyens de mise en forme du signal SG5 pour son émission sur le moyen SL de transfert de données en série.

Le module MODOUT comme le module MODIN sont adaptés à la nature du moyen SL de transfert de données et au format des messages respectivement émis ou reçus. Par exemple, on indiquera brièvement (ces modules n'étant pas en eux-mêmes propres à l'invention), que pour un moyen SL comprenant l'espace ambiant comme support de transmission par onde porteuse radiofréquence modulée en amplitude, le module d'entrée MODIN comporte un démodulateur, un filtre, un circuit de récupération de rythme, un circuit échantillonneur/bloqueur, des registres, des circuits logiques, etc. Le module de sortie MODOUT comporte quant à lui, dans cet exemple, un circuit de rise en forme d'un message, un oscillateur pour générer l'onde porteuse, un modulateur, un amplificateur, etc. Le moyen SL contient au moins une antenne, de préférence une seule pour l'émission et la réception de données par onde porteuse modulée en amplitude via l'air ambiant. En variante, on peut prévoir une antenne pour l'émission et une autre, distincte, pour la réception.

La bascule MS5 est préférentiellement une bascule monostable, par exemple dont l'unique état stable est l'état logique 0 et qui est mise dans son état instable complémentaire pendant une durée déterminée, à réception d'un front montant sur son entrée d'activation. De cette manière, on s'assure que l'unité de gestion ne peut rester de façon irrémédiable dans l'état de fonctionnement correspondant à l'émission du signal de données SG5, et qu'elle retournera d'elle-même dans un état d'attente pour recevoir d'autres mots de commande au bout de cette temporisation. On évite ainsi le risque de blocage de l'unité de gestion. Ce risque est particulièrement présent lorsque le moyen SL de transfert de données en série comprend un unique canal pour un sens de transfert et pour l'autre (moyen de transfert bidirectionnel).

A la figure 3, on a représenté, sous forme d'une table, une séquence de mots de commande qu'il faut successivement émettre vers l'unité de gestion pour réaliser une opération d'écriture d'un 0 logique dans le i-ème registre de la pile de la mémoire 10. Dans la colonne de gauche, on a indiqué le numéro des étapes nécessaires à cette opération. Dans celle de droite, on a indiqué par son nom le mot de commande qu'il convient d'émettre (voir figure 2).

A l'étape 1, on émet tout d'abord un mot START permettant de réveiller les circuits, de l'unité de gestion et de la mémoire 10 qui étaient mis en état de veille par souci de réduction de leur consommation en courant. Une première émission du mot CLOCK à l'étape 2₁ permet de faire passer le signal d'horloge SG2 à l'état logique 1. On génère ainsi un front montant qui active la mémoire 10. Une deuxième émission de ce même mot CLOCK à l'étape 3₁ permet de le refaire passer à l'état logique 0 pour préparer le front montant suivant. A chaque front montant du signal d'horloge SG2, un compteur de pile interne de la mémoire est incrémenté. La valeur logique présente dans le registre de la pile pointé par la valeur de ce compteur est alors délivrée sur la broche DATA de la mémoire 10.

L'émission successive de deux mots CLOCK est répétée i fois pour amener le compteur de pile à pointer sur le registre dans lequel on souhaite écrire.

Ensuite, on émet le mot IOIN0 à l'étape 4, ce qui provoque l'opération consistant à fermer la porte TS3 en sorte que le signal SG3 passe à l'état logique 0, i.e. la valeur logique 0 est imposée sur l'entrée DATA de la mémoire 10. On émet ensuite le mot RESET à l'étape 5, ce qui fait passer le signal SG1 à l'état logique 0. Selon le protocole de gestion propre à la mémoire 10 d'une carte téléphonique, les conditions ci-dessus permettent l'écriture de la valeur logique 0 dans le i-ème registre de la mémoire. Cette écriture est effectuée dès qu'un front montant du signal SG2 se présente sur l'entrée d'horloge CLK du circuit 10 de la mémoire. C'est ce qui se produit à l'étape 6 par l'émission de mot de commande CLOCK. Aux étapes 7, 8 et 9, l'émission des mots CLOCK, RESET et IOIN0 permet de ramener respectivement le signal d'horloge SG2 à l'état logique 0, le signal de commande SG1 à l'état logique 0, et le signal de données SG3 à l'état logique indéterminée HIZ.

Le front descendant du signal SG1 se présentant à l'étape 8 sur l'entrée RST de la mémoire, provoque la réinitialisation du compteur de pile de la mémoire.

A l'étape 10, l'émission du mot de commande STOP permet de conclure l'opération d'écriture. A réception de ce mot de commande, l'unité de gestion réalise un certain nombre d'actions comme par exemple la réinitialisation de ses registres internes R1, R2, R3 et R4 et la mise en état de veille de ses composants les plus consommateurs en courant.

Aux figures 4a à 4c, on a représenté des chronogrammes de l'évolution étape par étape du niveau logique des broches CLK, DATA et RST correspondant à l'état logique des signaux de gestion SG2, SG3 et SG1 respectivement.

On notera que l'ordre des étapes 4 et 5 d'une part et 8 et 9 d'autre part, peut être inversé puisqu'il est indifférent que ce soit le signal SG1 ou le signal SG3 qui commute le premier.

De plus, comme on l'aura compris, une opération d'écriture de la valeur logique 1 ne se distingue d'une opération d'écriture de la valeur logique 0 comme décrit ci-dessus en regard des figures 3 et 4a-4c que par le fait que le mot de commande IOIN1 doit être émis à la place du mot IOIN0 aux étapes 4 et 9 précitées.

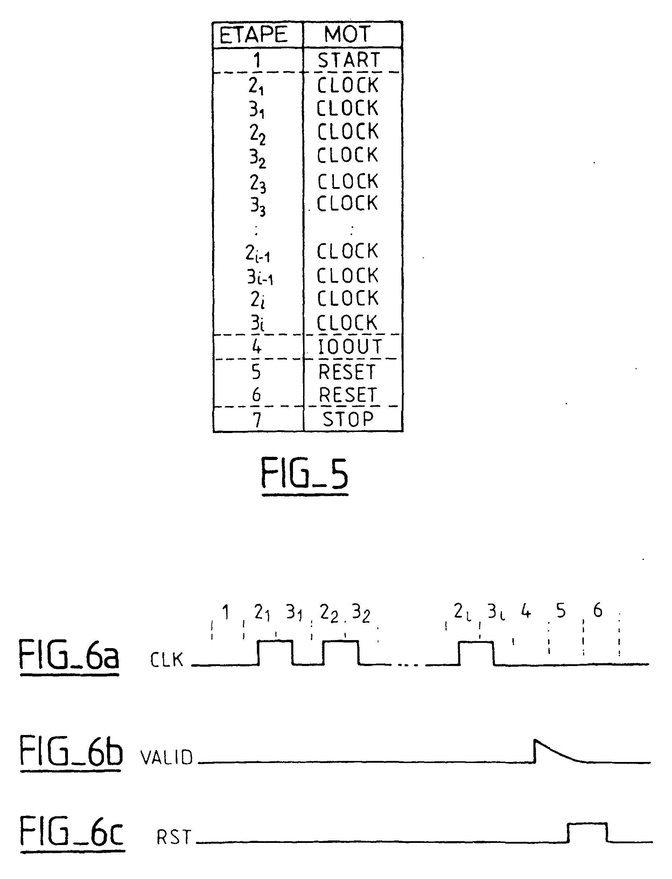

A la figure 5, on a représenté sous forme d'une table une séquence de mots de commande à émettre vers l'unité de gestion pour réaliser une opération de lecture de la valeur logique sauvegardée dans le i-ème registre de la mémoire 10.

Les étapes 1 à 3ᵢ de la figure 5 sont identiques aux étapes correspondantes de la figure 3 et permettent d'initialiser l'opération de lecture et de positionner le pointeur de pile de la mémoire 10 sur le i-ème registre. On rappelle que l'état logique sur la broche d'entrée/sortie DATA de la mémoire 10 correspond alors à la valeur logique sauvegardée dans ce i-ème registre.

A l'étape 4, l'émission du mot de commande IOOUT permet de faire passer le signal VALID en sortie de la bascule MS5 dans son état instable correspondant à la valeur logique 1. La valeur logique présente sur la broche d'entrée/sortie DATA est alors recopiée en sortie de la porte logique ET1 de type ET et détermine l'état logique du signal SG5. Celui-ci est fourni en entrée du module de sortie MODOUT en vue de l'émission de cette donnée logique par l'unité de gestion par l'intermédiaire du moyen de transfert de donnée en série SL. Avec un séquencenent adapté de l'unité de commande, la centrale de commande déportée peut recevoir et lire cette donnée à l'autre extrémité du moyen de transfert SL.

Aux étapes 5 et 6, l'émission deux fois successivement du mot de commande RESET permet de générer un front descendant sur l'entrée RST de la mémoire, ce qui provoque la réinitialisation de son compteur de pile interne.

Enfin, à l'étape 7, l'émission du not de commande STOP permet de conclure l'opération de lecture de la même façon que précédemment décrit pour l'opération d'écriture.

Aux figures 6a et 6c on a représenté des chronogrammes permettant de suivre étape après étape l'évolution des niveaux de tension respectivement sur la broche CLK de la mémoire, la sortie du monostable MS5 et sur la broche RST de la mémoire, correspondant à l'état logique des signaux respectivement SG2, VALID et SG1.

On notera que le niveau de tension en sortie du monostable MS5 décroit avec une rapidité dépendant de la constante de temps du monostable pour finalement s'annuler (figure 6b). Il n'est donc pas besoin de réémettre le mot de commande IOOUT pour ramener le signal VALID à l'état logique 0. On veillera bien entendu à ce que la constante de temps du monostable soit telle que le signal VALID soit à un niveau de tension correspondant à l'état logique 1 pendant une durée suffisante pour permettre la lecture et l'émission de la donnée lue dans la mémoire 10.

On peut enfin observer que, dans certains cas d'espèce, un même mot de commande pourrait provoquer le changement d'état logique de plusieurs signaux de gestion simultanément.

## Revendications

1. Procédé de gestion d'un circuit électronique (10) du type comportant au moins une broche d'accès pour recevoir et/ou délivrer n signaux de gestion (SG1-SG5), avec n strictement supérieur à l'unité, procédé consistant à générer, dans une unité de gestion, lesdits signaux de gestion à partir de données reçues en série par l'intermédiaire d'un unique moyen (SL) de transmission de données en série, et comprenant à cet effet les étapes suivantes :
a) extraction d'un mot de commande compris dans: les données reçues en série ;
b) décodage du mot de commande extrait à l'étape précédente pour, en fonction de la valeur du mot de commande, effectuer une opération modifiant l'état logique d'au moins un signal de gestion,
**caractérisé en ce que** :
- le signal de gestion est généré en vue d'être transmis sur une entrée adaptée du circuit électronique, deux opérations identiques successives ayant pour effet, respectivement, de faire passer le signal de gestion concerné d'un premier état logique à un second état logique différent du premier, et de le refaire passer dans l'état logique dans lequel il se trouvait à l'origine.

2. Procédé selon la revendication 1, **caractérisé en ce que**, le signal de gestion étant un signal de commande (SG1) ou un signal d'horloge (SG2) généré en vue d'être transmis, respectivement, sur une entrée de commande (RST) ou sur une entrée d'horloge (CLK) du circuit électronique, (10), l'opération consiste à faire basculer le signal d'un état logique déterminé 0 ou 1 dans lequel il se trouve vers l'état logique inverse de celui-ci.

3. Procédé selon la revendication 1, **caractérisé en ce que**, le signal de gestion étant un signal de données généré en vue d'être transmis sur une broche d'entrée/sortie de données (DATA) du circuit électronique (10), l'opération consiste à faire passer le signal de gestion (SG3) dans un état logique déterminé 0 ou 1 ou dans un état logique indéterminé HIZ.

4. Procédé selon l'une des revendications précédentes **caractérisé en ce que**, le signal de gestion étant un signal de données généré en vue d'être émis par l'unité de gestion sur le moyen de transfert de données, l'opération consiste à mettre le signal de gestion (SG5) dans un état logique déterminé, en fonction de l'état logique d'une broche d'entrée/sortie de données (DATA) du circuit électronique (10).

5. Unité de gestion pour la mise en oeuvre d'un procédé selon l'une quelconque des revendications précédentes, l'unité comprenant :
- des moyens (MODIN) d'extraction d'un mot de commande compris dans des données reçues en série par l'intermédiaire d'un moyen (SL) de transfert de données en série ;
- des moyens de décodage (R1-R4,DEC) dudit mot de commande ;
- **caractérisée en ce qu'**elle comprend en outre:
- des bascules (BT1-BT4: MS5) commandées par des signaux d'activation (H1-H5) générés par lesdits moyens de décodage, l'état logique de la sortie desdites bascules déterminant directement ou indirectement l'état logique des signaux de gestion générés par l'unité de gestion en vue d'être transmis sur une entrée adaptée d'un circuit électronique, les bascules étant commandées de sorte que deux opérations successives aient pour effet, respectivement de faire passer le signal de gestion concerné d'un premier état logique à un second état logique différent du premier, et de le refaire passer dans l'état logique dans lequel il se trouvait à l'origine.

6. Unité de gestion selon la revendication 5, notamment pour la mise en oeuvre d'un procédé selon la revendication 2, **caractérisé en ce qu'**un premier groupe de bascule (BT1-BT2) comprend des bascules de type T, la sortie de chacune de ces bascules délivrant un signal de gestion (SG1,SG2) et étant connectée à une entrée de commande (RST) ou une entrée d'horloge (CLK) du circuit électronique (10).

7. Unité de gestion selon la revendication 5, notamment pour la mise en oeuvre d'un procédé selon la revendication 3, **caractérisée en ce qu'**un second groupe de bascule (BT3-BT4) comprend deux bascules de type T, la sortie de chacune de ces bascules étant connectée à la borne de commande d'une porte logique à trois états (TS3,TS4) dont l'entrée est portée à un état logique déterminé 0 et 1 respectivement, et dont la sortie est connectée à une même broche d'entrée/sortie de données (DATA) du circuit électronique (10).

8. Unité de gestion selon la revendication 5, notamment pour la mise en oeuvre d'un procédé selon la revendication 4, **caractérisée en ce que** la sortie d'une (MS5) desdites bascules (BT1-BT4; MS5) est connectée à une première entrée d'une porte logique ET dont la seconde entrée est connectée à la broche d'entrée/sortie de données (DATA) du circuit électronique (10), et dont la sortie délivre le signal de données émis par l'unité de gestion sur le moyen de transfert de données en série (SL) .

9. Unité de gestion selon la revendication 8, **caractérisée en ce que** ladite bascule (MS5) est un circuit monostable.

10. Unité de gestion selon l'une des revendications 5 à 9, **caractérisée en ce que** le circuit électronique est une mémoire de carte téléphonique.

11. Unité de gestion selon l'une des revendications 5 à 10, **caractérisée en ce que** le moyen de transfert de données en série (SL) est une liaison radiofréquence.

## Claims

1. Method of controlling an electronic circuit (10) of the type having at least one access pin for receiving and/or delivering n control signals (SG1-SGS), with n strictly greater than the unit, method consisting of generating, in a control unit, said control signals from data received in-series through the intermediary of a single means (SL) for transmitting data in series, and to that end comprising the following steps:
a) extraction of a command word included in the data received in series;
b) decoding of the command word extracted in the preceding step for carrying out, as a function of the value of the command word, an operation altering the logic state of at least one control signal,
**characterized in that**:
the control signal is generated with a view to being transmitted to a suitable input of the electronic circuit, two identical successive operations having the effect, respectively, of having the control signal concerned change from a first logic state to a second logic state different from the first, and of having it change again into the logic state in which it was originally.

2. Method according to Claim 1, **characterized in that**, the control signal being a command signal (SG1) or a clock signal (SG2) generated with a view to being transmitted, respectively, to a command input (RST) or to a clock input (CLK) of the electronic circuit (10), the operation consists of having the signal change from a given logic state 0 or 1 in which it finds itself to the inverse logic state.

3. Method according to Claim 1, **characterized in that**, the control signal being a data signal generated with a view to being transmitted to a data input/output pin (DATA) of the electronic circuit (10), the operation consists of having the control signal (SG3) change to a given logic state 0 or 1 or to an indeterminate logic state HIZ.

4. Method according to one of the preceding claims, **characterized in that**, the control signal being a data signal generated with a view to being transmitted by the control unit to the data transfer means, the operation consists of setting the control signal (SG5) to a given logic state as a function of the logic state of a data input/output pin (DATA) of the electronic circuit (10).

5. Control unit for implementing a method according to any one of the preceding claims, the unit comprising:
means (MODIN) for extracting a command word included in data received in series through the intermediary of means (SL) for transferring data in series;
means (R1-R4, DEC) for decoding said command word;
**characterized in that** it also comprises:
- flip-flops (BT1-BT4; MS5) controlled by activation signals (H1-H5) generated by said decoding means, the logic state of the output of said flip-flops determining directly or indirectly the logic state of the control signals generated by the control unit with a view to being transmitted to a suitable input of an electronic circuit, the flip-flops being controlled so that two successive operations have the effect, respectively, of having the control signal concerned change from a first logic state to a second logic state different from the first, and of having it change again into the logic state in which it was originally.

6. Control unit according to Claim 5, specifically for implementing a method according to Claim 2, **characterized in that** a first flip-flop group (BT1-BT2) comprises T-type flip-flops, the output of each of these flip-flops delivering a control signal (SG1, SG2) and being connected to a command input (RST) or a clock input (CLK) of the electronic circuit (10).

7. Control unit according to Claim 5, specifically for implementing a method according to Claim 3, **characterized in that** a second flip-flop group (BT3-BT4) comprises two T-type flip-flops, the output of each of these flip-flops being connected to the command terminal of a three-state logic gate (TS3, TS4) of which the input is brought to a given logic state 0 and 1 respectively, and of which the output is connected to the same data input/output pin (DATA) of the electronic circuit (10).

8. Control unit according to Claim 5, specifically for implementing a method according to Claim 4, **characterized in that** the output of one (MS5) of said flip-flops (BT1-BT4; MS5) is connected to a first input of a logic gate ET of which the second input is connected to the data input/output pin (DATA) of the electronic circuit (10), and of which the output delivers the data signal transmitted by the control unit to the means for transferring data in series (SL).

9. Control unit according to Claim 8, **characterized in that** said flip-flop (MS5) is a monostable circuit.

10. Control unit according to one of Claims 5 to 9, **characterized in that** the electronic circuit is a phonecard memory.

11. Control unit according to one of Claims 5 to 10, **characterized in that** the means for transferring data in series (SL) is a radio-frequency link.

## Patentansprüche

1. Steuerverfahren für eine elektronische Schaltung (10) der Art mit zumindest einem Zugangsstift zum Empfang und/oder zum Aussenden von n Steuersignalen (SG1-SG5), wobei n streng größer als die Einheit ist, wobei das Verfahren daraus besteht, in einer Steuereinheit die Steuersignale ausgehend von Daten zu erzeugen, die seriell mittels einer einzigen Vorrichtung (SL) zur seriellen Datenübertragung empfangen werden, und das zu diesem Zweck die folgenden Schritte umfasst:
a) Auslesen eines in den seriell empfangenen Daten enthaltenen Steuerwortes;
b) Dekodierung des in dem vorherigen Schritt ausgelesenen Steuerwortes, um in Abhängigkeit von dem Wert des Steuerwortes einen Vorgang durchzuführen, der den logischen Zustand wenigstens eines Steuersignals ändert,
**dadurch gekennzeichnet, dass**:
- das Steuersignal im Hinblick darauf erzeugt wird, an einen dafür eingerichteten Eingang der elektronischen Schaltung übertragen zu werden, wobei zwei aufeinander folgende identische Vorgänge jeweils bewirken, dass das betreffende Steuersignal von einem ersten logischen Zustand in einen zweiten logischen Zustand, der sich von dem ersten unterscheidet, versetzt wird, und dass das Steuersignal wieder zurück in den logischen Zustand versetzt wird, in dem es sich am Anfang befand.

2. Verfahren gemäß Anspruch 1, **dadurch gekennzeichnet, dass** im Hinblick darauf, dass das Steuersignal ein Befehlssignal (SG1) oder ein Taktsignal (SG2) ist, das erzeugt wird, um jeweils an einen Befehlseingang (RST) oder einen Taktgebereingang (CLK) der elektronischen Schaltung (10) übertragen zu werden, der Vorgang daraus besteht, das Signal von einem mit 0 oder 1 bestimmten logischen Zustand, in dem es sich befindet, in dessen umgekehrten logischen Zustand schwingen zu lassen.

3. Verfahren gemäß Anspruch 1, **dadurch gekennzeichnet, dass** im Hinblick darauf, dass das Steuersignal ein Datensignal ist, das erzeugt wird, um an einen Dateneingangs-/-ausgangsstift (DATA) der elektronischen Schaltung (10) übertragen zu werden, der Vorgang daraus besteht, das Steuersignal (SG3) in einen mit 0 oder 1 bestimmten logischen Zustand oder in einen unbestimmten logischen Zustand HIZ übergehen zu lassen.

4. Verfahren gemäß einem der vorherigen Ansprüche, **dadurch gekennzeichnet, dass** im Hinblick darauf, dass das Steuersignal ein Datensignal ist, das erzeugt wird, um von der Steuereinheit an die Datenübertragungsvorrichtung ausgesandt zu werden, der Vorgang daraus besteht, das Steuersignal (SG5) in einen bestimmten logischen Zustand zu versetzen, und zwar in Abhängigkeit von dem logischen Zustand eines Dateneingangs-/-ausgangsstiftes (DATA) der elektronischen Schaltung (10).

5. Steuereinheit zur Durchführung eines Verfahrens gemäß irgendeinem der vorherigen Ansprüche, wobei die Einheit umfasst:
- Vorrichtungen (MODIN) zum Auslesen eines Steuerwortes, das in Daten enthalten ist, die seriell mittels einer Vorrichtung (SL) zur seriellen Datenübertragung empfangen werden;
- Vorrichtungen zur Dekodierung (R1-R4, DEC) des Steuerwortes;
- **dadurch gekennzeichnet, dass** sie außerdem aufweist:
- Kippschaltungen (BT1-BT4; MS5), welche von Aktivierungssignalen (H1-H5) gesteuert werden, die von den Dekodiervorrichtungen erzeugt werden, wobei der logische Zustand des Ausgangs der Kippschaltungen unmittelbar oder mittelbar den logischen Zustand der Steuersignale bestimmt, die von der Steuereinheit im Hinblick darauf erzeugt werden, an einen dafür eingerichteten Eingang einer elektronischen Schaltung übertragen zu werden, wobei die Kippschaltungen derart gesteuert werden, dass zwei aufeinander folgende Vorgänge jeweils bewirken, das betreffende Steuersignal von einem ersten logischen Zustand in einen zweiten logischen Zustand, der sich von dem ersten unterscheidet, zu versetzen, und das Steuersignal wieder zurück in den logischen Zustand zu versetzen, in dem es sich am Anfang befand.

6. Steuereinheit gemäß Anspruch 5, insbesondere zur Durchführung eines Verfahrens gemäß Anspruch 2, **dadurch gekennzeichnet, dass** eine erste Kippschaltungsgruppe (BT1-BT2) Kippschaltungen der Art T aufweist, wobei der Ausgang jeder dieser Kippschaltungen ein Steuersignal (SG1, SG2) aussendet und an einen Befehlseingang (RST) oder einen Taktgebereingang (CLK) der elektronischen Schaltung angeschlossen ist.

7. Steuereinheit gemäß Anspruch 5, insbesondere zur Durchführung eines Verfahrens gemäß Anspruch 3, **dadurch gekennzeichnet, dass** eine zweite Kippschaltungsgruppe (BT3-BT4) zwei Kippschaltungen der Art T aufweist, wobei der Ausgang jeder dieser Kippschaltungen an die Steuerklemme eines logischen Ports mit drei Zuständen (TS3, TS4) angeschlossen ist, dessen Eingang in einen jeweils mit 0 und 1 bestimmten logischen Zustand versetzt wird, und dessen Ausgang an ein und denselben Dateneingangs-/-ausgangsstift (DATA) der elektronischen Schaltung (10) angeschlossen ist.

8. Steuereinheit gemäß Anspruch 5, insbesondere zur Durchführung eines Verfahrens gemäß Anspruch 4, **dadurch gekennzeichnet, dass** der Ausgang einer (MS5) der Kippschaltungen (BT1-BT4; MS5) an einen ersten Eingang eines logischen Ports ET angeschlossen ist, dessen zweiter Eingang an den Dateneingangs-/-ausgangsstift (DATA) der elektronischen Schaltung (10) angeschlossen ist, und dessen Ausgang das Datensignal liefert, das von der Steuereinheit an die Vorrichtung zur seriellen Datenübertragung (SL) ausgesandt wird.

9. Steuereinheit gemäß Anspruch 8, **dadurch gekennzeichnet, dass** die Kippschaltung (MS5) eine monostabile Schaltung ist.

10. Steuereinheit gemäß einem der Ansprüche 5 bis 9, **dadurch gekennzeichnet, dass** die elektronische Schaltung ein Telefonkartenspeicher ist.

11. Steuereinheit gemäß einem der Ansprüche 5 bis 10, **dadurch gekennzeichnet, dass** die Vorrichtung zur seriellen Datenübertragung (SL) eine Hochfrequenzverbindung ist.
